# EUROPÄISCHE PATENTSCHRIFT

(11) **EP 1 428 419 B1**
(45) Veröffentlichungstag und Bekanntmachung des Hinweises auf die Patenterteilung: **23.06.2010**
(21) Anmeldenummer: 02760156.6
(22) Anmeldetag: 03.09.2002
(51) Int. Cl.: H05K 7/20, H02B 1/56

(54) **AKTIV AUSSENGEKÜHLTES GEHÄUSE MIT ZUMINDEST EINEM WÄRMEVERLUSTLEISTUNGSERZEUGENDEN ELEKTRONIKBAUSTEIN**
HOUSING WITH ACTIVE EXTERNAL COOLING AND AT LEAST ONE ELECTRONIC COMPONENT WITH HEAT-DISSIPATING CAPACITY
BOITIER A REFROIDISSEMENT EXTERIEUR ACTIF COMPORTANT AU MOINS UN MODULE ELECTRONIQUE GENERANT DE LA CHALEUR DISSIPEE

(30) Priorität: 06.09.2001 DE 10143547
(43) Veröffentlichungstag der Anmeldung: 16.06.2004
(73) Patentinhaber: Rexroth Indramat GmbH, 97803 Lohr am Main (DE)
(72) Erfinder: STRAUSS, Hans-Rüdiger, 97816 Lohr am Main (DE)
(86) Internationale Anmeldenummer: PCT/DE2002/003236
(87) Internationale Veröffentlichungsnummer: WO 2003/024176

(56) Entgegenhaltungen:
- EP-A- 0 297 308
- DE-U- 8 130 651
- PATENT ABSTRACTS OF JAPAN vol. 1998, no. 09, 31. Juli 1998 (1998-07-31) & JP 10 108323 A (YASKAWA ELECTRIC CORP), 24. April 1998 (1998-04-24)

## Beschreibung

Die Erfindung betrifft ein aktiv außengekühltes Gehäuse mit zumindest einem wärmeverlustleistungserzeugenden Elektronikbaustein nach dem Oberbegriff des Anspruchs 1.

Ein solches aktiv außengekühltes Gehäuse hat einen verlustleistungserzeugenden Elektronikbaustein, der an einer Seitenwandung des Gehäuses liegt. Die durch diesen Elektronikbaustein erzeugte Wärmeverlustleistung kann somit größtenteils über die entsprechende Seitenwandung des Gehäuses abgeführt werden. Hierzu ist eine Lüftereinheit außerhalb des Gehäuses vorgesehen, die einen Luftstrom erzeugt, der durch einen seitlichen Strömungskanal geführt ist, welcher gerade die genannte Seitenwandung mit dem Elektronikbaustein beströmt.

Bei der genannten Ausgestaltung des Standes der Technik wird im wesentlichen lediglich die genannte Seitenwandung gekühlt, wohingegen die übrigen Seiten des Gehäuses praktisch ungekühlt bleiben und somit eine sehr inhomogene Kühlung erreicht wird, die zu Wärmenestern, insbesondere an der Oberseite des Gehäuses führt, so dass die Leistung der enthaltenen Elektronik im wesentlichen durch die genannte Geometrie eingeschränkt ist. Zu dem kann es bei der genannten Ausgestaltung zur Verschmutzung der Lüftereinheit bzw. von deren Motor kommen, insbesondere wenn das Gehäuse'in einer Produktionshalle mit Verunreinigung der Umgebungsluft stationiert ist. Ein solches aktiv außengekühltes Gehäuse ist aus dem Dokument DE 81 30 651 U bekannt.

Es ist daher Aufgabe der vorliegenden Erfindung, ein aktiv außengekühltes Gehäuse der eingangs genannten Art derart weiterzubilden, dass sie insgesamt - hinsichtlich der Elektronik und der Lüftereinheit - bessere, d.h. insbesondere längere Standzeiten, auch in Umgebungen mit verunreinigter Umgebungsluft und andererseits eine verbesserte Kühlleistung und damit eine vergleichsweise hohe elektrische Leistung der Elektronikkomponenten des Gehäuses aufweist.

Diese Aufgabe wird gelöst durch die Merkmale des Anspruchs 1.

Hierzu ist die Lüftereinheit in einem - vorzugsweise von dem Gehäuse separaten - Lüftergehäuse angeordnet. Dieses sitzt an der Oberseite des aktiv gekühlten Gehäuses. Dabei ist die durch die Lüftereinheit erzeugte Strömung derart, dass sie durch einen Lufteinlass über eine Lufteinlassöffnung des Lüftergehäuses erfolgt, die an der Unterseite des Lüftergehäuses angeordnet ist und die im wesentlichen nach vertikal unten offen ist. Dadurch ist die Lüftereinheit geschützt gegen Verunreinigungen der Umgebungsluft, insbesondere Flüssigkeitströpfchen sowie größere, herabsinkende Tröpfchen und Verunreinigungen.

Nach dem Lufteinlass passiert die Kühlluft das Lüftergehäuse und tritt dann durch einen seitlichen Luftaustritt des Lüftergehäuses in einen seitlichen Strömungskanal ein.

Dadurch wird - neben der Seitenwandung mit dem verlustleistungserzeugenden Elektronikbaustein - auch die Oberseite des Gehäuses effizient gekühlt. Hierauf wird später noch näher eingegangen.

Durch die Geometrie ist die Lüftereinheit praktisch spritzwassergeschützt bzw. geschützt gegen die genannten Verunreinigungen/Flüssigkeitströpfchen angeordnet. Dadurch wird auch die Lebensdauer der Lüftereinheit erhöht, da diese nicht mehr - wie beim Stand der Technik - in hohem Maße mit solchen Verunreinigungen beaufschlagt ist.

Hierzu ist das Lüftergehäuse bis auf die genannte Lufteinlassöffnung praktisch allseitig geschlossen. Dadurch wird die Luft von unten nach oben durch die unten angeordnete Lufteinlassöffnung angesaugt, so dass herabsinkende Verunreinigungen nur sehr wenig oder praktisch gar nicht angesaugt werden. Dies gilt insbesondere auch für Spritzwasser, welches praktisch nicht in das Lüftergehäuse eintreten und damit auch nicht in Berührung mit der Lüftereinheit kommen kann. Durch die Anordnung der Lufteinlassöffnung auf der Unterseite des Lüftergehäuses entsteht prinzipiell noch der Vorteil, dass auch der Luftstrom, der durch diese Lufteinlassöffnung angesaugt wird, noch an einer Gehäusewandung vorbeistreifen und diese zu dem effektiv kühlen kann. Hierauf wird später noch näher eingegangen.

Bevorzugte Ausgestaltungen der vorliegenden Erfindung sind in den Unteransprüchen beschrieben.

Um einerseits die durch im Geräteinnern aufsteigende, warme Luft erwärmte Geräteoberseite des Gehäuses durch die Ansaugluft mitkühlen zu können und andererseits den Anteil von mitangesaugten Verunreinigungen der Umgebungsluft weiter zu minimieren, wird vorgeschlagen, dass das Lüftergehäuse die Geräteoberseite des Gehäuses zumindest teilweise überdeckt und dass die Lufteinlassöffnung im wesentlichen gegenüber der Gehäuseoberseite angeordnet ist, so dass ein Spalt zwischen der Gehäuseoberseite und der Unterseite des Lüftergehäuses gebildet wird, über welchen die Kühlluft größtenteils angesogen wird. Vorzugsweise ist das Lüftergehäuse praktisch mit seinem ganzen Grundriss gegenüber, d.h. oberhalb der Geräteoberseite des Gehäuses angeordnet, so dass es diese praktisch vollständig überdeckt. Durch den gebildeten Spalt wird die Kühlluft angesaugt, so dass sie zunächst nach oben gefördert, im Lüftergehäuse umgelenkt und in dem Seitenkanal nach vertikal unten weitergefördert wird. Dieser Umlenkeffekt des Kühlluftstromes bewirkt eine Verringerung einerseits der Beaufschlagung der Lüftereinheit mit Verunreinigungen, andererseits auch eine Verringerung der Mitnahme von Verunreinigungen des bzw. in den Seitenkahal(s). Die vergleichsweise schweren und vorzugsweise nicht schwebenden, sondern herabsinkenden Teilchen, wie beispielsweise Spritzwasser etc. werden durch diese Umlenkung zu einem Großteil von der angesaugten Luft nicht mitgenommen und verbleiben somit außerhalb des Lüftergehäuses bzw. des Seitenkanals. Dies liegt vor allem daran, dass die vergleichsweise schweren Teilchen der Umlenkung durch die entgegenwirkende Schwerkraft nicht folgen können. In einer bevorzugten Ausgestaltung wird die Kühlluft daher - zur Optimierung der genannten Effekte - praktisch vollständig über den sich bildenden Spalt zwischen Gehäuseoberseite und Unterseite des Lüftergehäuses angesaugt.

Hierbei ist es wesentlich, dass die Spaltgeometrie einerseits einen nicht zu großen Strömungswiderstand bietet und andererseits aber auch noch ein Kühleffekt der Geräteoberseite erzielt wird. Daher wird vorgeschlagen, dass der effektive Ansaugquerschnitt der Spaltgeometrie der Lüfter-Gehäuse-Anordnung größer oder gleich dem effektiven Einlassquerschnitt der Lufteinlassöffnung ist. Dadurch ist bereits gewährleistet, dass die Kühlluft auch tatsächlich größtenteils über den Spalt angesaugt wird und gleichzeitig der Strömungsweg über den Spalt einen nicht zu großen Strömungswiderstand darstellt, so dass insgesamt die Effizienz der Kühlung nicht oder lediglich geringfügig beeinträchtigt wird.

Des weiteren wird vorgeschlagen, dass die Spaltbreite unter Berücksichtigung des Arbeitspunktes des Ventilators und der effektiven Strömungscharakteristik in Lüftergehäuse und angeschlossenem Seitenkanal derart bemessen ist, dass in dem Spalt eine die Gehäuseoberfläche effektiv kühlende Kühlluftströmung gebildet wird.
Dies stellt im wesentlichen eine Bedingung für den Abtransport der an der Gehäuseoberseite anfallenden, im wesentlichen aus dem Gehäuseinneren stammenden Verlustleistungswärme dar. Hierzu darf der Spalt nicht zu groß sein. In Versuchen, die die Anmelderin durchgeführt hat, hat ein Verhältnis des Ansaugquerschnitts des Spaltes (dies ist im wesentlichen die freie Öffnung des Spaltumfangs entlang des korrespondierenden Gehäuseumfangs) zu dem effektiven Einlassquerschnitt der Lufteinlassöffnung von 1:1 bis 3:1 die besten Resultate geliefert. Dies bedeutet, dass der effektive Einlassquerschnitt der Spaltgeometrie gleich groß bis drei mal so groß ist wie der Lufteinlässquerschnitt der Einlassöffnung.

Dabei ist aber auch noch der Arbeitspunkt der Lüftereinheit zu beachten. Je größer die Leistung der Lüftereinheit ist, desto größer ist auch das genannte Verhältnis, gleichzeitig ist bei größerem Strömungswiderstand der Strömungscharakteristik in Lüftergehäuse und angeschlossenem Seitenkanal das Verhältnis entsprechend kleiner zu wählen. Dabei bedeutet größer, dass das Verhältnis im oberen Bereich also zwischen 1,5:1 bis 3:1 liegt, kleiner bedeutet, dass das genannte Verhältnis im Bereich 1,5:1 bis 1 bzw. knapp unter 1:1 angesiedelt ist.

Durch die angegebenen Dimensionierungen, die natürlich nur Richtlinien darstellen können und nicht abschließend alle Möglichkeiten der Auslegung wiedergeben, wird aber doch eine praktisch die gesamte obere Gehäuseoberfläche effektiv kühlende Kühlluftströmung realisiert.

Durch die Führung des Luftstroms im seitlichen Strömungskanal im wesentlichen entgegen der natürlichen Konvektionsrichtung, nämlich vertikal abwärts, wird erreicht, dass eine sehr effektive Zwangskühlung entsteht, da die Luft im oberen Bereich des Strömungskanals noch relativ kühl ist und im unteren Bereich schon demgegenüber etwas erwärmt. Im oberen Bereich ist daher die Kühlung am stärksten, wie dies bei einer natürlichen Konvektion genau umgekehrt der Fall wäre.

Hinsichtlich einer effektiven Kühlung sind die Anforderungen besonders hoch, wenn das Gehäuse eine Antriebsreglerelektronik enthält. Hier kommen die erfindungsgemäßen Lehren besonders zum Tragen: denn einerseits können in einer Antriebsreglerelektronik die erforderlichen Leistungselektronikbausteine vergleichsweise einfach an der entsprechenden Seitenwandung mit dem Seitenkanal angeordnet werden; andererseits ist gerade bei einem Gehäuse für eine Antriebsreglerelektronik eine Kühlung an mehreren Seiten von Vorteil, da die anfallende Verlustleistung sehr hoch ist und beispielsweise die Geräteoberseite durch die Innenkonvektion im Gerätegehäuse zusätzlich stark erwärmt wird. Hinzu kommt, dass die Standzeiten für eine Antriebsreglerelektronik sehr hoch sind; es kann durchaus vorkommen, dass eine Antriebsreglerelektronik für einen sehr langen Zeitraum praktisch ununterbrochen in Betrieb ist und Leistung erzeugen muss. Denn durch die vorteilhafte Ausgestaltung der Kühlung wird auch die Kühleffizienz - bei insgesamt gleichbleibender Leistung einer Lüftereinheit - gesteigert und gleichzeitig trotzdem eine höhere Betriebsdauer für die Lüftereinheit und damit auch für die Antriebsreglerelektronik erzielt. Hieraus ergibt sich ein Doppelnutzen der Erfindung.

Bei dem Antrieb von elektrischen Maschinen mittels der Antriebsreglerelektronik müssen die entsprechenden elektrischen Maschinen, z.B. Elektromotoren ggf. auch gebremst werden. Solch eine elektrische Maschine wird gelegentlich oder auch dauernd und wiederkehrend gebremst, wobei der Elektromotor entsprechend elektrische Energie in Form von Spannung bzw. Stromfluss zurückspeist. Für die Dissipation von zurückgespeister Energie ist in der Regel ein Bremswiderstand vorhanden. Bei einem Bremsvorgang fällt - je nach Umdrehungszahl bzw. Geschwindigkeit der verbundenen elektrischen Maschine - ein sehr hoher Wärmeverlustleistungsanteil an. Dieser Bremswiderstand kann außen an dem Gehäuse der Antriebsreglerelektronik angebracht sein. Dann hat die Erfindung einen weiteren Synergieeffekt bzw. Zusatznutzen, wenn dieser Bremswiderstand derart in dem seitlichen Strömungskanal angeordnet ist, dass dieser von dem entsprechenden Luftstrom umströmt wird. Er wird vorzugsweise allseitig umströmt; es reicht in der Regel aber auch aus, wenn der Bremswiderstand lediglich im wesentlichen an einer Großfläche längs umströmt wird.

In jedem Fall wird dann die Luftströmung in dem seitlichen Strömungskanal sowohl zur Kühlung der Seitenwandung und damit der Leistungselektronik als auch zur Kühlung des entsprechenden Bremswiderstandes gleichzeitig verwendet. Dabei ist vorzugsweise der Bremswiderstand bezüglich der zu kühlenden Seitenwandung auf Abstand angeordnet, so dass zwischen Bremswiderstand und zu kühlender Wandung keine Wärmenester entstehen, die beidseitig aufgeheizt würden.

Um eine effektive Wärmeabfuhr von dem Bremswiderstand zu ermöglichen, ist der Bremswiderstand vorzugsweise in ein Aluminium-Gehäuse eingefasst. Das Aluminium-Gehäuse dient einerseits dazu eventuelle Verunreinigungen des Kühlluftstroms von dem Bremswiderstand fernzuhalten, andererseits eine gute Wärmeableitung zu gewährleisten; Aluminium hat einen hohen Wärmeleitwert, so dass es hierfür besonders gut geeignet ist. Vorzugsweise wird ein Strangpressprofil verwendet, da der Bremswiderstand in der Regel länglich ausgeführt ist und ein Strangpressprofil einerseits die erforderlichen Geometrieanforderungen zur Einfassung des Bremswiderstandes erfüllt und andererseits eine Längs-Vorzugsrichtung hat, so dass er effizient dadurch gekühlt werden kann, dass er längs umströmt wird.

Zur besseren Ableitung der Wärme wird vorgeschlagen, dass der in das Aluminium-Gehäuse eingefasste Bremswiderstand praktisch in der lokalen Umströmungsrichtung verlaufende Kühlrippen hat.

Der bzw. die verlustleistungserzeugende(n) Elektronikbaustein(e) sind beispielsweise Transistoren, wofür in der Antriebsreglertechnik meist IGBT's verwendet werden.

Neben den in der Antriebsreglertechnik verwendeten IGBT's sind auch noch andere Elektronikbauteile vorhanden, die eine vergleichsweise große elektrische Verlustleistung erzeugen. Hierzu gehören auch Kondensatoren, insbesondere Kondensatoren zur Stützung eines Gleichspannungszwischenkreises. Es hat sich als vorteilhaft erwiesen, dass diese Kondensatoren im oberen Bereich des Innenraumes des Gehäuses an derjenigen Seitenwandung sitzen, über die der seitliche Luftstrom durch den seitlichen Strömungskanal geführt ist. Dabei ist bevorzugt, dass die Kondensatoren im oberen Drittel der Höhe des Gehäuses sitzen. Im oberen Bereich der Zwangskühlluftströmung ist die Kühlwirkung am höchsten, so dass auch dort die genannten Kondensatoren vorteilhafterweise angeordnet sind; denn diese Kondensatoren sind in der Regel sehr anfällig gegenüber Wärmeeinflüssen. Die Anordnung im oberen Bereich zusammen mit der vorteilhaften Kühlgeometrie der vorliegenden Erfindung erhöht somit einerseits die Kühlwirkungsleistung und andererseits die Lebensdauer der betreffenden Kondensatoren.

Die Erfindung wird anhand eines in den Figuren dargestellten Ausführungsbeispiels näher erläutert. Es zeigen:
Figur 1 eine perspektivische Ansicht eines Gehäuses mit einer Antriebsreglerelektronik und mit einer erfindungsgemäßen Lüftereinrichtung,
Figur 2 eine Seitenansicht des Gerätes aus Figur 1, wie dort mit dem Pfeil II bezeichnet, Figur 3 einen Schnitt entlang III-III, wie in Figur 2 gezeigt,
Figur 4 einen Schnitt entlang IV-IV, wie in Figur 2 gezeigt.

Sofern im Folgenden nichts anderes gesagt ist, beziehen sich alle Bezugszeichen stets auf alle Figuren.

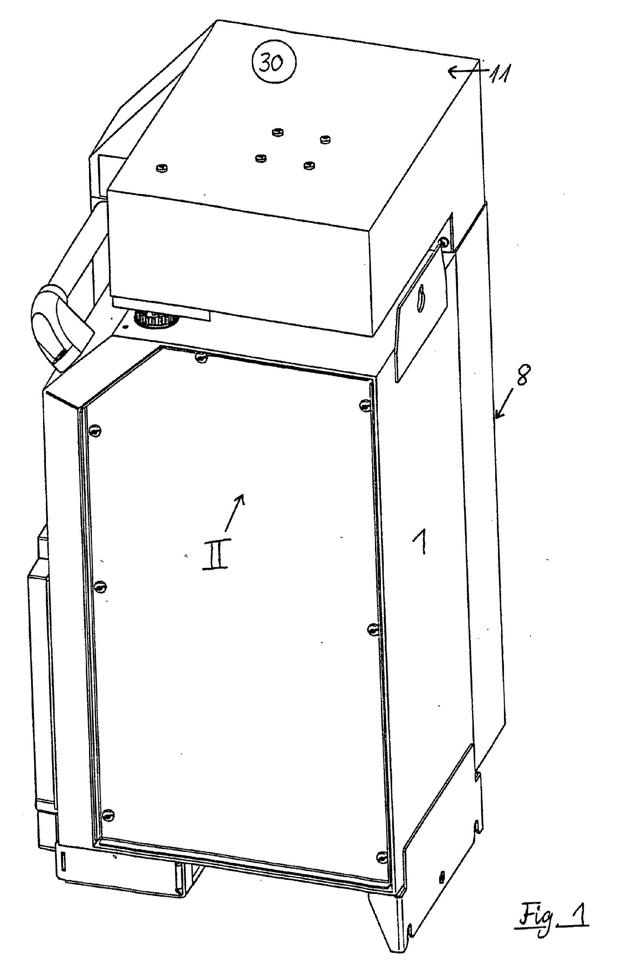

Figur 1 ist eine perspektivische Ansicht eines aktiv außengekühlten Gehäuses (1) mit einer erfindungsgemäßen Kühlvorrichtung. Das Gehäuse (1) hat mehrere wärmeverlustleistungserzeugende Elektronikbausteine (2,3); es handelt sich um ein Antriebsgehäuse, wobei die verlustleistungserzeugenden Elektronikbausteine IGBT's (2) und Kondensatoren (3), insbesondere zur Stützung eines Gleichspannungszwischenkreises, sind. Eine Lüftereinheit (4) sitzt in einem Lüftergehäuse (11), welches an der Oberseite (13) des aktiv gekühlten Gehäuses (1) sitzt. Die folgende Beschreibung erfolgt unter gleichzeitiger Bezugnahme auf die Figuren 1 bis 3.

In dem Lüftergehäuse (11) ist die Lüftereinheit (4) angeordnet, und zwar an der Oberseite (13) des Lüftergehäuses (11). Sie ist an der Oberseite (13) mit den vier gezeigten Schrauben angeschraubt. Die Lüftereinheit (4) ist mit ihrem Lüfterrad (36) praktisch axial fluchtend mit dem Einlassquerschnitt (16) einer Lufteinlassöffnung (10) angeordnet. Durch die fluchtende Anordnung mit kleinem Abstand zur Lufteinlassöffnung (10) wird die Kühlluft effektiv gefördert. Die Lufteinlassöffnung (10) ist unten mit einem Schutzgitter (37) zum Schutz gegen Eingriff in das Lüftergehäuse (11) versehen. Das Lüftergehäuse (11) weist einen seitlichen Luftaustritt (43) auf, der in einen seitlichen Strömungskanal (8) mündet, der an derjenigen Seitenwandung (9) des gekühlten Gehäuses (1) liegt, an welcher die verlustleistungserzeugenden Elektronikbausteine (2,3) angeordnet sind. Dadurch wird diese Seitenwandung (9) besonders effektiv gekühlt und die Wärme dort, wo sie entsteht, direkt abgeführt. Die Kondensatoren (3) sitzen im oberen Bereich (22) des Innenraumes (23), so dass sie sowohl durch den Luftstrom (7) - über die Seitenwandung (9) - als auch durch die Kühlung der Oberfläche (18) vor Übererwärmung geschützt sind. Wesentlich ist, dass der Lufteinlass lediglich durch eine Lufteinlassöffnung (10) an der Unterseite des Lüftergehäuses (11) erfolgt, wobei die Lufteinlassöffnung (10) auch lediglich nach vertikal unten (12) offen ist, so dass die Lüftereinheit (4) geschützt gegen Verunreinigungen der Umgebungsluft im Lüftergehäuse (11) angeordnet ist. Durch die gezeigte Geometrie wird insgesamt eine vorteilhafte Kühlung erreicht, die zudem praktisch indifferent ist gegenüber herabsinkenden Verunreinigungen, wie beispielsweise Spritzwasser. Dies wird lediglich durch einfache, geometrische Dimensionierungen und Anordnungen erreicht: das Lüftergehäuse (11) ist oberhalb der Oberfläche (18) des aktiv zu kühlenden Gehäuses (1) angeordnet, wobei die Unterseite des Lüftergehäuses (11) - dort wo die Lufteinlassöffnung (10) angeordnet ist - gegenüber der Oberseite (18) angeordnet ist. Hierzu überdecken sich Unterseite (15) des Lüftergehäuses (11) und Oberseite (18) des Gehäuses (1); dies bedeutet, dass insoweit die Grundrisse einander entsprechen und praktisch übereinander in einer Flucht angeordnet sind. Dadurch entsteht zwischen Unterseite (15) und Oberfläche (18) ein Spalt (14), über den die Umgebungsluft angesaugt wird. Dabei kommt es einerseits darauf an, dass die Geometrie derart ausgelegt ist, dass insgesamt ein nicht zu hoher Strömungswiderstand beim Ansaugen der Umgebungsluft auftritt, dass aber andererseits die Ansauggeschwindigkeit der Umgebungsluft - und zwar dort, wo der Spalt (14) in die Umgebung übergeht - eine nicht zu hohe Ansauggeschwindigkeit auftritt, so dass Verunreinigungen in geringem Maße bis gar nicht mit angesaugt werden.

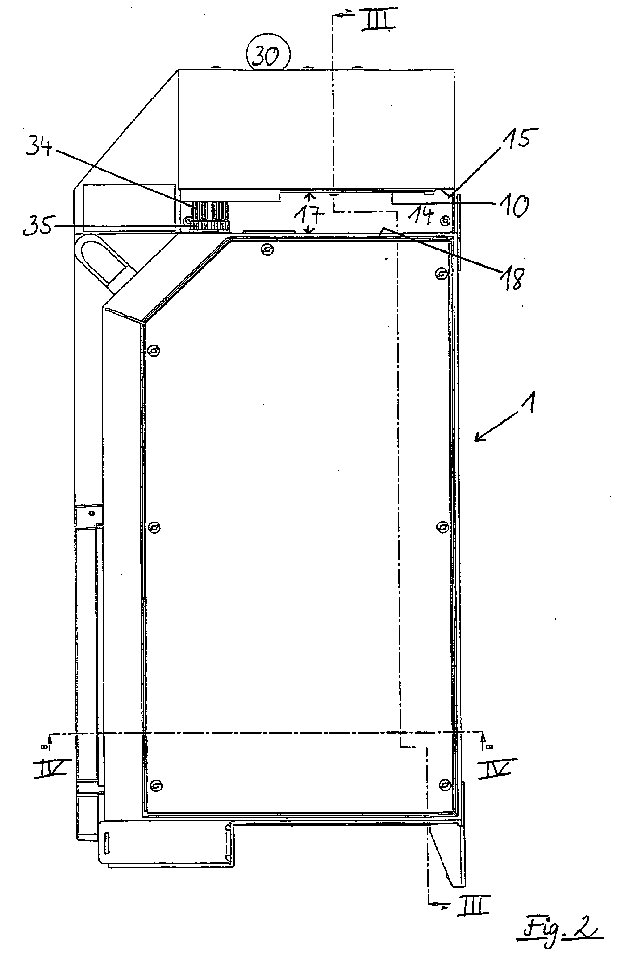

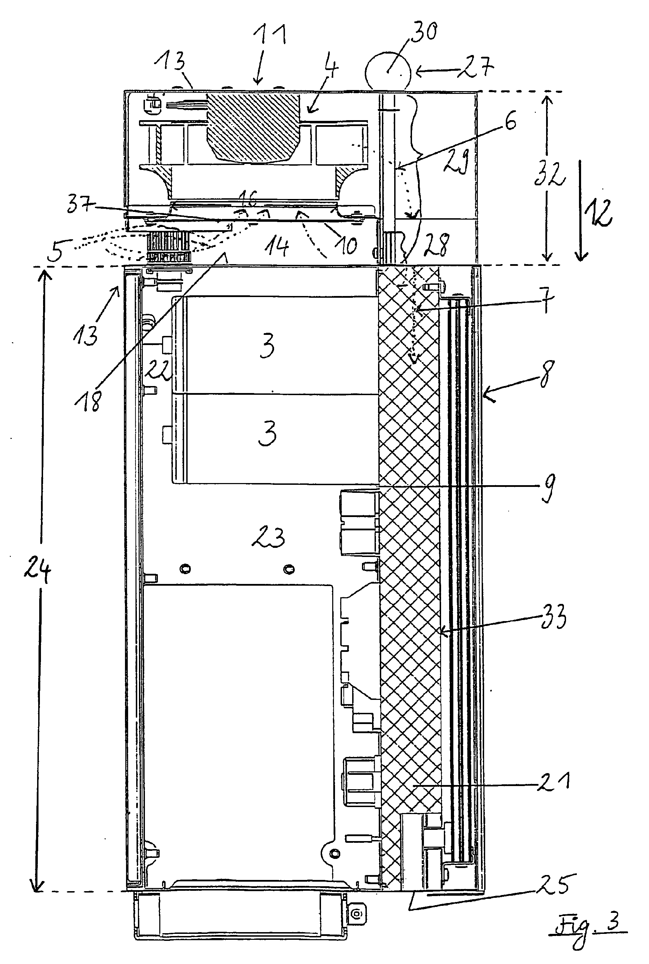

Der effektive Ansaugquerschnitt der Spaltgeometrie des Spaltes (14) ist daher im gezeigten Ausführungsbeispiel größer als der effektive Einlassquerschnitt (16) der Lufteinlassöffnung (10). Dabei ist der effektive Ansaugquerschnitt im wesentlichen gleich der Summe der (hier rechteckförmigen) Trennebenen zwischen Spalt und Umgebung, das ist beispielsweise in Figur 2 die Rechteckfläche, als die sich der Spalt (14) in der Frontalansicht darstellt. Im gezeigten Ausführungsbeispiel wäre damit der effektive Einlassquerschnitt gleich dem doppelten der genannten Fläche plus derjenigen Fläche, in der sich der Spalt (14) in der Ansicht der Figur 3 darstellt, dass ist die zu der oben genannten Fläche der Figur 2 senkrechte Fläche.

Wie durch die Pfeile (5) der Luftströmung im Bereich des Spaltes (14) angedeutet, entsteht eine resultierende Strömung, die die Oberfläche (18) des Gehäuses (1) effektiv kühlt. Hierzu ist die Spaltbreite (17) unter Berücksichtigung des Arbeitspunktes der Lüftereinheit (4) und der effektiven Strömungscharakteristik im Lüftergehäuse (11) und angeschlossenem seitlichen Strömungskanal (8) entsprechend bemessen. Dadurch, dass Lüftergehäuse (11) bzw. Unterseite (10) des Lüftergehäuses (11) und Oberfläche (18) des Gehäuses (1) sich praktisch vollständig überdecken bzw. miteinander fluchten, wird auch praktisch die gesamte obere Oberfläche (18) des Gehäuses (1) effektiv gekühlt. Dies ist von großem Vorteil, da die erwärmte Luft im Inneren des Gehäuses (1) sich ja gerade im oberen Bereich (13) des Gehäuses (1) ansammelt und hier eine Kühlung daher besonders effektiv ist. Dadurch wird u.a. auch eine Kühlkonvektion im Innenraum (23) des Gehäuses (1) gefördert. Falls im Innenraum (23) noch eine zusätzliche Luftumwälzung (hier nicht gezeigt), z.B. zur Vermeidung von Wärmenestern, vorgesehen ist, wird noch eine zusätzliche, indirekte Kühlung praktisch des gesamten Innenraumes (23) erreicht. Insgesamt ergibt sich also allein schon durch die Kühlung der Oberfläche (18) des Gehäuses (1) ein wesentlicher Vorteil, der die Lebensdauer der Kondensatoren (3) erhöhen dürfte und es auch erlauben dürfte, insgesamt eine höhere elektrische Leistung der Antriebsreglerelektronik bei gleicher oder vergleichbarer Kühlleistung vorzusehen.

Trotzdem ist die angesaugte Kühlluft noch nicht stark erwärmt, so dass immer noch über die Kühlrippen (21), die in den Seitenkanal (8) eingeschlossen sind, effektiv sowohl die Gehäuse-Seitenwandung (9) als auch die darauf angebrachten Leistungselektronik-Bausteine (2,3) gekühlt werden.

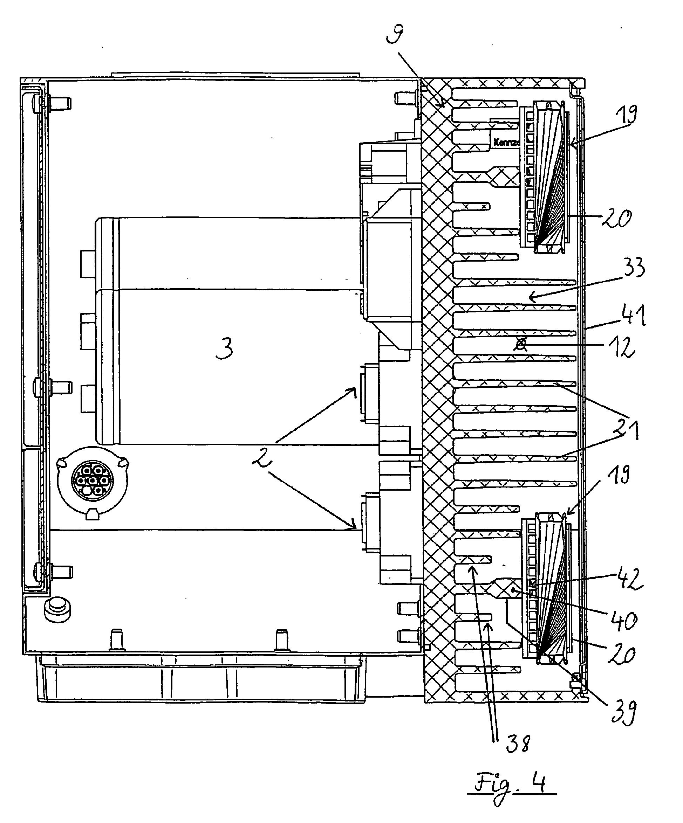

Dazu wird der Luftstrom (6) entgegen der natürlichen Konvektionsrichtung vertikal abwärts (12) zu einem Luftstrom (7) umgelenkt, der durch einen Lufteinlass (26) in den seitlichen Strömungskanal (8) ein- und an einem unteren Luftaustritt (25) austritt, wobei der seitliche Strömungskanal (8) durch eine Außenwand (41) umfangsmäßig geschlossen ist. Die Kühlwirkung des Kühlluftstroms (7) durch den seitlichen Strömungskanal (8) wird zudem dazu verwendet, einen außen an dem Gehäuse innerhalb des - geschlossenen - Seitenkanals (8) angebrachten Bremswiderstand (19) über sein Gehäuse (20) zu kühlen. Dieser wird von dem Luftstrom (7) umströmt. Um die Kühlung zu verbessern, hat der Bremswiderstand praktisch in der lokalen Umströmungsrichtung (entsprechend der Vertikalrichtung (12)) verlaufende Kühlrippen (44); dies ist in Figur 4 zu sehen. In dem Längsbereich, in welchem der Bremswiderstand montiert ist, sind die Kühlrippen des Kühlkörpers (33) zu kurzen Kühlrippen (38) verkürzt, so dass zwischen der Seitenwandung (9) und dem Bremswiderstand (19) noch genügend Strömungsraum zur Verfügung steht, so dass sowohl die Seitenwandung (9) als auch der jeweilige Bremswiderstand (19) gekühlt werden. Die mittlere der Kühlrippen ist an ihrer Oberseite zu einem Montagekopf (40) verbreitert, in welchen eine Schraube (42) zur Montage des Bremswiderstandes (19) eingreift. Durch die Verdickung bietet diese Montagerippe (39) ausreichende Festigkeit.

Das Lüftergehäuse (11) ist mittels einer langen Schraube (27), deren Schaft (29) praktisch die gesamte Höhe (32) des Lüftergehäuses (11) vertikal durchgreift, an dem Gehäuse (1) befestigt. Die Schraube (27) ist mit ihrem unteren Gewindeabschnitt (28) in ein korrespondierendes Befestigungsgewindeloch (31) des Gehäuses (1) eingeschraubt. An ihrer Oberseite hat die Schraube (27) einen Knauf (30) zur Betätigung/zum Lösen bzw. zum Anziehen. Die Stecker (34)-Buchsen (35)-Kombination zum elektrischen Anschluss der Lüftereinheit ist derart dimensioniert, dass ein vorbestimmter Abstand (17) (nämlich die Breite des Spaltes (14)) zwischen Gehäuseoberseite (18) und Lüftergehäuse-Unterseite (10) dadurch eingehalten ist. Zugleich übt die Stecker (34)-Buchen (35)-Kombination eine Abstützfunktion des Lüftergehäuses (11) gegenüber der Oberseite (18) des Gehäuses (1) aus. Sie bietet in diesem Fall einen zusätzlichen Abstützbereich für den überhängenden Teil des Lüftergehäuses (11).

### Bezugszeichenliste

- 1: Gehäuse
- 2: Elektrischer Leistungsschalter
- 3: Kondensator
- 4: Lüftereinheit
- 5: Luftstrom
- 6: Luftstrom
- 7: Luftstrom
- 8: Seitlicher Strömungskanal
- 9: Seitenwandung
- 10: Lufteinlassöffnung
- 11: Lüftergehäuse
- 12: Vertikalrichtung
- 13: Oberseite des Gehäuses
- 14: Spalt
- 15: Unterseite des Lüftergehäuses
- 16: Einlassquerschnitt
- 17: Spaltbreite
- 18: Obere Gehäuseoberfläche
- 19: Bremswiderstand
- 20: Gehäuse des Bremswiderstandes
- 21: Kühlrippen
- 22: Oberer Bereich des Innenraums des Gehäuses
- 23: Innenraum des Gehäuses
- 25: Unterer Luftaustritt
- 26: Lufteinlass des seitlichen Strömungskanals
- 27: Schraube
- 28: Gewindeabschnitt der Schraube
- 29: Schaftabschnitt der Schraube
- 30: Knauf
- 32: Höhe des Lüftergehäuses
- 33: Kühlkörper
- 34: Stecker
- 35: Buchse
- 36: Lüfterrad
- 37: Schutzgitter
- 38: Kurze Kühlrippen
- 39: Montagerippen
- 40: Montagerippenkopf
- 41: Außenwand des seitlichen Strömungskanals
- 42: Schraube für Befestigung des Bremswiderstandes

## Patentansprüche

1. Aktiv außengekühltes Gehäuse (1) mit zumindest einem wärmeverlustleistungserzeugenden Elektronikbaustein (2,3), mit einer außerhalb des Gehäuses (1) angeordneten Lüftereinheit (4), die einen Luftstrom (5,6,7) erzeugt, der durch einen seitlichen Strömungskanal (8) geführt ist, welcher an derjenigen Seitenwandung (9) des gekühlten Gehäuses (1) liegt, an welcher zumindest ein verlustleistungserzeugender Elektronikbaustein (2,3) angeordnet ist, **dadurch gekennzeichnet, dass** die Lüftereinheit (4) in einem Lüftergehäuse (11) angeordnet ist, welches an der Oberseite (13) des aktiv gekühlten Gehäuses (1) sitzt und einen seitlichen Luftaustritt aufweist, der in den seitlichen Strömungskanal (8) einmündet, wobei der Lufteinlass lediglich durch eine Lufteinlassöffnung (10) des Lüftergehäuses (11) erfolgt, welche an der Unterseite des Lüftergehäuses (11) angeordnet ist und welche im wesentlichen nach vertikal unten (12) offen ist, so dass die Lüftereinheit (4) geschützt gegen Verunreinigungen der Umgebungsluft, insbesondere herabsinkende Verunreinigungen, insbesondere spritzwassergeschützt im Lüftergehäuse (11) angeordnet ist.

2. Aktiv außengekühltes Gehäuse nach Anspruch 1, **dadurch gekennzeichnet, dass** das Lüftergehäuse (11) die Gehäuseoberseite (13) zumindest teilweise überdeckt und dass die Lufteinlassöffnung (10) im wesentlichen gegenüber der Gehäuseoberseite (13) angeordnet ist, so dass ein Spalt (14) zwischen der Gehäuseoberseite (13) und der Unterseite des Lüftergehäuses (11) gebildet wird, über welchen die Kühlluft größtenteils angesaugt wird.

3. Aktiv außengekühltes Gehäuse nach Anspruch 2, **dadurch gekennzeichnet, dass** der effektive Einlassquerschnitt der Spaltgeometrie der Lüfter (4)-Gehäuse (1)-Anordnung größer oder gleich dem effektiven Einlassquerschnitt (16) der Lufteinlassöffnung (10) ist.

4. Aktiv außengekühltes Gehäuse nach Anspruch 2 oder 3, **dadurch gekennzeichnet, dass** die Spaltbreite (17) unter Berücksichtigung des Arbeitspunktes der Lüftereinheit und der effektiven Strömungscharakteristik in Lüftergehäuse (11) und angeschlossenem seitlichen Strömungskanal (8) derart bemessen ist, dass in dem Spalt (14) eine die obere Gehäuseoberfläche (18), insbesondere praktisch die gesamte obere Gehäuseoberfläche (18), effektiv kühlende Kühlluftströmung (5) resultiert.

5. Aktiv außengekühltes Gehäuse nach einem der Ansprüche 1 bis 4, **dadurch gekennzeichnet, dass** der Luftstrom (7) durch den seitlichen Strömungskanal (8) im wesentlichen entgegen der natürlichen Konvektionsrichtung vertikal abwärts (12) gerichtet ist.

6. Aktiv außengekühltes Gehäuse nach einem der Ansprüche 1 bis 4, **dadurch gekennzeichnet, dass** das Gehäuse (1) eine Antriebsreglerelektronik enthält.

7. Aktiv außengekühltes Gehäuse nach Anspruch 6, **dadurch gekennzeichnet, dass** ein außen an dem Gehäuse (1) angebrachter Bremswiderstand (19) derart in dem seitlichen Strömungskanal (8) angeordnet ist, dass dieser von dem entsprechenden Luftstrom (7) umströmt wird.

8. Aktiv außengekühltes Gehäuse nach Anspruch 7, **dadurch gekennzeichnet, dass** der Bremswiderstand (19) in ein Aluminium-Gehäuse (20), vorzugsweise aus einem Strangpressprofil, eingefasst ist.

9. Aktiv außengekühltes Gehäuse nach Anspruch 8, **dadurch gekennzeichnet, dass** das Aluminium-Gehäuse (20) praktisch in der lokalen Umströmungsrichtung verlaufende Kühlrippen (44) hat.

10. Aktiv außengekühltes Gehäuse nach einem der Ansprüche 6 bis 9, **dadurch gekennzeichnet, dass** im oberen Bereich (22) des Innenraumes (21) des Gehäuses (1) an derjenigen Seitenwandung (9), über die der seitliche Luftstrom (7) durch den seitlichen Strömungskanal (8) geführt ist, Kondensatoren (3), insbesondere Kondensatoren (3) zur Stützung eines Gleichspannungszwischenkreises, sitzen.

11. Aktiv außengekühltes Gehäuse nach Anspruch 10, **dadurch gekennzeichnet, dass** die Kondensatoren (3) im oberen Drittel der Höhe des Gehäuses sitzen.

12. Aktiv außengekühltes Gehäuse nach einem der Ansprüche 1 bis 11, **dadurch gekennzeichnet, dass** in einer vorbestimmten, fluchtenden Relativstellung (Montagestellung) von Luftaustritt des Lüftergehäuses (11) in den seitlichen Strömungskanal (8) und Lufteinlass (26) des seitlichen Strömungskanals (8) einfach zugängliche und zu lösende und zu befestigende Befestigungspaarungen (27) zur Verbindung und/oder formschlüssigen, relativen Fixierung von Lüftergehäuse (11) und Gehäuse (1) vorgesehen sind.

13. Aktiv außengekühltes Gehäuse nach Anspruch 12, **dadurch gekennzeichnet, dass** eine lange Schraube (27) vorgesehen ist, deren Schaft (29) praktisch die gesamte Höhe (32) des Lüftergehäuses (11) vertikal durchgreift und in korrespondierende Befestigungs-Gewindelöcher des Gehäuses (1) und/oder eines Kühlkörpers (33) einzuschrauben ist, so dass das Lüftergehäuse (11) an dem Gehäuse (1) befestigt ist.

14. Aktiv außengekühltes Gehäuse nach einem der Ansprüche 1 bis 13, **dadurch gekennzeichnet, dass** eine Stecker (34)-Buchsen (35)-Kombination zum elektrischen Anschluss der Lüftereinheit (4) derart dimensioniert ist, dass ein vorbestimmter Abstand (17) zwischen Gehäuseoberseite (13) und Lüftergehäuseunterseite eingehalten ist und/oder die Stecker (34)-Buchsen (35)-Kombination eine Abstützfunktion des Lüftergehäuses (11) gegenüber der Oberseite des Gehäuses (1) hat.

## Claims

1. Actively externally cooled housing (1) having at least one electronic component (2, 3) which produces power losses in the form of heat, having a fan unit (4) which is arranged outside the housing (1) and produces an air stream (5, 6, 7) which is routed through a lateral flow channel (8) which is situated on that side wall (9) of the cooled housing (1) on which at least one electronic component (2, 3) which produces power losses is arranged, **characterized in that** the fan unit (4) is arranged in a fan housing (11) which is situated on the upper face (13) of the actively cooled housing (1) and has a lateral air outlet which issues into the lateral flow channel (8), with air being let in only through an air inlet opening (10) in the fan housing (11), the said air inlet opening being arranged on the lower face of the fan housing (11) and being open substantially in the vertically downward direction (12), and therefore the fan unit (4) being arranged in the fan housing (11) so as to be protected against contaminants in the surrounding air, in particular sinking contaminants, in particular protected against splashing water.

2. Actively eternally cooled housing according to Claim 1, **characterized in that** the fan housing (11) at least partially covers the housing upper face (13), and **in that** the air inlet opening (10) is arranged substantially opposite the housing upper face (13), and therefore a gap (14) is formed between the housing upper face (13) and the lower face of the fan housing (11), a large portion of the cooling air being drawn in via the said gap by suction.

3. Actively externally cooled housing according to Claim 2, **characterized in that** the effective inlet cross section of the gap geometry of the fan (4)/housing (1) arrangement is greater than or equal to the effective inlet cross section (16) of the air inlet opening (10).

4. Actively externally cooled housing according to Claim 2 or 3, **characterized in that** the gap width (17) is dimensioned taking into account the operating point of the fan unit and the effective flow characteristic in the fan housing (11) and the connected lateral flow channel (8) in such a way that a cooling air flow (5) which effectively cools the upper housing surface (18), in particular virtually the entire upper housing surface (18), results.

5. Actively externally cooled housing according to one of Claims 1 to 4, **characterized in that** the air stream (7) is directed vertically downwards (12) through the lateral flow channel (8) substantially against the natural convection direction.

6. Actively externally cooled housing according to one of Claims 1 to 4, **characterized in that** the housing (1) contains a drive control electronics system.

7. Actively externally cooled housing according to Claim 6, **characterized in that** a braking resistor (19) which is mounted on the housing (1) is arranged in the lateral flow channel (8) in such a way that the corresponding air stream (7) flows around the said braking resistor.

8. Actively externally cooled housing according to Claim 7, **characterized in that** the braking resistor (19) is enclosed in an aluminium housing (20), preferably comprising an extruded profile.

9. Actively externally cooled housing according to Claim 8, **characterized in that** the aluminium housing (20) has cooling ribs (44) which run virtually in the local circulating direction.

10. Actively externally cooled housing according to one of Claims 6 to 9, **characterized in that** capacitors (3), in particular capacitors (3) for supporting a DC voltage intermediate circuit, are situated in the upper region (22) of the interior (21) of the housing (1) on that side wall (9) across which the lateral air stream (7) is guided through the lateral flow channel (8).

11. Actively externally cooled housing according to Claim 10, **characterized in that** the capacitors (3) are situated in the upper third of the height of the housing.

12. Actively externally cooled housing according to one of Claims 1 to 11, **characterized in that** easily accessible fastening pairs (27) which can be released and fastened are provided for connecting and/or fixing the fan housing (11) and the housing (1) relative to one another in an interlocking manner in a predetermined, aligned relative position (assembly position) of the air outlet of the fan housing (11) into the lateral flow channel (8) and the air inlet (26) of the lateral flow channel (8).

13. Actively externally cooled housing according to Claim 12, **characterized in that** a long screw (27) is provided, the shaft (29) of the said screw passing vertically through virtually the entire height (32) of the fan housing (11) and it being possible for the said shaft to be screwed into corresponding fastening threaded holes of the housing (1) and/or of a heat sink (33), so that the fan housing (11) is fastened to the housing (1).

14. Actively externally cooled housing according to one of Claims 1 to 13, **characterized in that** a plug (34)/socket (35) combination for electrically connecting the fan unit (4) is dimensioned in such a way that a predetermined distance (17) is maintained between the housing upper face (13) and the fan housing lower face and/or the plug (34)/socket (35) combination has a supporting function for the fan housing (11) in relation to the upper face of the housing (1).

## Revendications

1. Boîtier (1) à refroidissement extérieur actif, comprenant au moins un module électronique (2, 3) générant de la chaleur dissipée, une unité de ventilateur (4) disposée en dehors du boîtier (1), qui produit un courant d'air (5, 6, 7), qui est guidé à travers un canal d'écoulement latéral (8), qui s'applique contre la paroi latérale (9) du boîtier (1) refroidi contre laquelle est disposé au moins un module électronique (2, 3) générant de la puissance dissipée, **caractérisé en ce que** l'unité de ventilateur (4) est disposée dans un boîtier de ventilateur (11), qui repose sur le côté supérieur (13) du boîtier à refroidissement actif et qui présente une sortie d'air latérale, qui débouche dans le canal d'écoulement latéral (8), l'entrée d'air s'effectuant uniquement par une ouverture d'entrée d'air (10) du boîtier de ventilateur (11), qui est disposée sur le côté inférieur du boîtier de ventilateur (11) et qui est ouverte essentiellement verticalement vers le bas (12), de sorte que l'unité de ventilateur (4) soit protégée contre les impuretés de l'air ambiant, notamment des impuretés descendantes, notamment qu'elle soit protégée contre l'eau de projection dans le boîtier de ventilateur (11).

2. Boîtier à refroidissement extérieur actif selon la revendication 1, **caractérisé en ce que** le boîtier de ventilateur (11) recouvre au moins en partie le côté supérieur du boîtier (13) et **en ce que** l'ouverture d'entrée d'air (10) est disposée essentiellement en regard du côté supérieur du boîtier (13), de sorte qu'une fente (14) entre le côté supérieur du boîtier (13) et le côté inférieur du boîtier de ventilateur (11) soit formée, par le biais de laquelle l'air de refroidissement est aspiré pour la majeure partie.

3. Boîtier à refroidissement extérieur actif selon la revendication 2, **caractérisé en ce que** la section transversale d'entrée efficace de la géométrie de la fente de l'agencement ventilateur (4) - boîtier (1) est supérieure ou égale à la section transversale d'entrée efficace (16) de l'ouverture d'entrée d'air (10).

4. Boîtier à refroidissement extérieur actif selon la revendication 2 ou 3, **caractérisé en ce que** la largeur de fente (17) est dimensionnée en tenant compte du point de travail de l'unité de ventilateur et de la caractéristique d'écoulement efficace dans le boitier de ventilateur (11) et du canal d'écoulement latéral (8) raccordé, de telle sorte que dans la fente (14) se produise un écoulement d'air de refroidissement (5) à refroidissement efficace de la surface supérieure du boîtier (18), notamment pratiquement de toute la surface supérieure du boîtier (18).

5. Boîtier à refroidissement extérieur actif selon l'une quelconque des revendications 1 à 4, **caractérisé en ce que** le courant d'air (7) est orienté verticalement vers le bas (12) par le canal d'écoulement latéral (8) essentiellement à l'encontre de la direction de convexion naturelle.

6. Boîtier à refroidissement extérieur actif selon l'une quelconque des revendications 1 à 4, **caractérisé en ce que** le boîtier (1) contient une électronique de régulation d'entraînement.

7. Boîtier à refroidissement extérieur actif selon la revendication 6, **caractérisé en ce que** qu'une résistance de freinage (19) montée à l'extérieur sur le boîtier (1) est disposée dans le canal d'écoulement latéral (8) de telle sorte qu'elle soit entourée par la circulation du courant d'air (7) correspondant.

8. Boîtier à refroidissement extérieur actif selon la revendication 7, **caractérisé en ce que** la résistance de freinage (19) est incorporée dans un boîtier en aluminium (20), de préférence constitué d'un profilé filé.

9. Boîtier à refroidissement extérieur actif selon la revendication 8, **caractérisé en ce que** le boîtier en aluminium (20) a des nervures de refroidissement (44) s'étendant pratiquement dans la direction locale de circulation de l'écoulement.

10. Boîtier à refroidissement extérieur actif selon l'une quelconque des revendications 6 à 9, **caractérisé en ce que** dans la région supérieure (22) de l'espace intérieur (21) du boîtier (1) sur la paroi latérale (9) par le biais de laquelle le courant d'air latéral (7) est guidé à travers le canal d'écoulement latéral (8), sont disposés des condensateurs (3), notamment des condensateurs (3) pour assister un circuit intermédiaire de tension continue.

11. Boîtier à refroidissement extérieur actif selon la revendication 10, **caractérisé en ce que** les condensateurs (3) reposent dans le tiers supérieur de la hauteur du boîtier.

12. Boîtier à refroidissement extérieur actif selon l'une quelconque des revendications 1 à 11, **caractérisé en ce que** dans une position relative prédéterminée en affleurement (position de montage) depuis la sortie d'air du boîtier de ventilateur (11) dans le canal d'écoulement latéral (8) et l'entrée d'air (26) du canal d'écoulement latéral (8), des appariements de fixation (27) facilement accessibles et pouvant être desserrés et fixés, sont prévus pour la connexion et/ou pour la fixation relative par engagement par correspondance géométrique du boîtier de ventilateur (11) et du boîtier (1).

13. Boîtier à refroidissement extérieur actif selon la revendication 12, **caractérisé en ce que** l'on prévoit une longue vis (27), dont la tige (29) vient en prise verticalement pratiquement avec toute la hauteur (32) du boîtier de ventilateur (11) et peut être vissée dans des trous de filetage de fixation correspondants du boîtier (1) et/où d'un corps de refroidissement (33), de sorte que le boîtier de ventilateur (11) soit fixé sur le boîtier (1).

14. Boîtier à refroidissement extérieur actif selon l'une quelconque des revendications 1 à 13, **caractérisé en ce qu'**une combinaison connecteur mâle (34) - connecteur femelle (35) pour le raccordement électrique de l'unité de ventilateur (4) est dimensionnée de telle sorte qu'une distance prédéterminée (17) entre le côté supérieur du boîtier (13) et le côté inférieur du boîtier de ventilateur soit conservée et/ou la combinaison connecteur mâle (34) - connecteur femelle (35) a une fonction de support du boîtier de ventilateur (11) par rapport au côté supérieur du boîtier (1).
